# EUROPÄISCHE PATENTSCHRIFT

(11) **EP 0 558 797 B1**
(45) Veröffentlichungstag und Bekanntmachung des Hinweises auf die Patenterteilung: **06.09.2000**
(21) Anmeldenummer: 92117152.6
(22) Anmeldetag: 08.10.1992
(51) Int. Cl.: H01J 37/34

(54) **Vorrichtung zur Kathodenzerstäubung**
Cathodic sputtering device
Dispositif de pulvérisation cathodique

(30) Priorität: 29.01.1992 DE 4202349
(43) Veröffentlichungstag der Anmeldung: 08.09.1993
(73) Patentinhaber: Balzers und Leybold Deutschland Holding Aktiengesellschaft, 63450 Hanau (DE)
(72) Erfinder: Sichmann, Eggo, W-6460 Gelnhausen (DE)

(56) Entgegenhaltungen:
- EP-A- 0 330 445
- EP-A- 0 450 163
- US-A- 4 604 180

## Beschreibung

Die Erfindung betrifft eine Vorrichtung für die Herstellung dünner Schichten auf einem Substrat mittels eines Plasmas in einer Vakuumprozeßkammer, im wesentlichen bestehend aus Magneten, Polschuhen, einer Anode, einem als Kathode ausgebildeten Target aus dem zu zerstäubenden Werkstoff und einer Abschirmung, wobei die dem Substrat zugewandte, zu zerstäubende Vorderseite des Targets im wesentlichen dachförmig verläuft und die Dachflächen symmetrisch zur Rotationsachse des Targets ausgeführt sind und die Dachform durch mindestens zwei oder mehr Ebenen gebildet wird und die Senkrechten, die auf den Vorderseiten der beiden längsten Ebenen erzeugbar sind, ihren gemeinsamen Schnittpunkt vor dem Target haben.

Zur Herstellung dünner Schichten auf einem Substrat, vorzugsweise zur Beschichtung von Compact Discs, sind zum Stand der Technik vielfältige Lösungen bekannt.

So beschreibt beispielsweise die EP 0 163 445 einen Targetsatz für eine Vorrichtung zum Sputtern im Vakuum mit einem ersten und zweiten Kathodenelement aus Sputtermaterial, wobei das zweite das erste umgibt, die Geometrien des ersten und zweiten Elementes so sind, daß, wenn sie sich im Vakuum befinden, Material von der emittierenden Oberfläche des zweiten Elementes, dessen Oberfläche außerhalb derjenigen des ersten Elementes liegt, gesputtert werden kann und daß das erste Targetelement eine ringförmige Kathode ist und die anfängliche emittierende Oberfläche des zweiten Elementes kegelstumpfförmig ist.

Eine weitere Schrift US 4,747,926 beansprucht ebenfalls ein kegelstumpfförmiges Sputtertarget zum Einsatz in einer Magnetronsputtervorrichtung, im wesentlichen bestehend aus einem einstückigen Target mit zwei Oberflächenbereichen, die parallel zum zentralen Bereich eines planaren Substrates verlaufen und einem dritten geneigten Bereich, der den ersten und zweiten Bereich verbindet, einer Tragplatte sowie Mitteln zur Erzeugung eines Magnetfeldes für die Erzeugung von zwei Plasmen verschiedenen Durchmessers.

Als weitere Schritt sei die US 4,933,064 genannt. Diese beansprucht eine Sputterkathode nach dem Magnetronprinzip mit einem Target mit wenigstens zwei durchgehenden, konzentrischen Vorsprüngen, deren Wandflächen senkrecht zur Sputterfläche verlauten, ein Permanentmagnetsystem mit weichmagnetischen Polschuhen, von deren Polflächen aus Magnetfeldlinien die Sputterfläche kreuzen.

Schließlich ist eine Magnetronkathode zum Sputtern dünner Schichten bekannt (EP 0 330 445) mit einem kreisscheibenförmigen Target, dessen dem Substrat zugewandte zu zerstäubende Vorderseite etwa dachförmig verläuft, wobei die Dachfläche symmetrisch zur Rotationsachse des Targets verläuft und die Dachform durch zwei Ebenen gebildet wird, deren auf ihren Vorderseiten erzeugbare Senkrechten ihren gemeinsamen Schnittpunkt vor dem Target haben, wobei auf der dem Substrat abgewandten Seite des Targets eine Targetrückenplatte angeordnet ist, an der die Polschuhe eines Magnete aufweisenden Jochs anliegen.

Die bekannten Vorrichtungen der infrage stehenden Art haben alle den Nachteil, daß sie erstens eine relativ hohe elektrische Anschlußleistung für die Sputterstromversorgung benötigen, daß sie zweitens einen nur unbefriedigenden Wirkungsgrad beim Sputtern erreichen, d. h. daß zuviel Targetwerkstoff auf Abschirmungen und Blenden niedergeschlagen wird, anstatt auf dem Substrat, daß drittens der mechanische Aufbau der Kathode zu aufwendig ist und daß viertens die Störanfälligkeit der Sputterstromversorgung - SSV, bedingt durch Arcs zu groß ist und es damit zu häufigen Abschaltungen der SSV kommt.

Der Erfindung liegt daher die Aufgabe zugrunde, alle die obengenannten Nachteile zu minimieren beziehungsweise abzustellen und die Vorrichtung somit betriebssicherer, zuverlässiger und preiswerter in der Herstellung sowie im Betrieb zu machen.

Diese Aufgabe wird erfindungsgemäß gelöst, indem
a) nur ein Magnetsatz mit einem das Target umgebenden ersten Polschuh und einem zentral angeordneten zweiten Polschuh verwendet wird, wobei das Target den zweiten Polschuh umgibt,
b) die dem Substrat zugewandten Stirnseiten der Polschuhe mit einer Schräge versehen sind, wobei die Schräge des ersten Polschuhs zur Rotationsachse hin zeigt und die Schräge des zweiten Polschuhs von der Rotationsachse weg zeigt.

Durch die gewählte Targetgeometrie wird eine fokussierende Sputterrichtung erreicht, wodurch der Anteil der Teilchen, die sich auf dem Substrat niederschlagen, erhöht und der Anteil, der auf die umgebenden Bauteile auftrifft, reduziert und der Wirkungsgrad meßbar verbessert wird.

Durch den dachförmigen Knick der Targetoberfläche wird in diesem Knick ein elektrostatischer Einschluß der Elektronen erzielt und damit auch die Zündbedingung für einen ersten Plasmaring erfüllt.

Durch diesen "Knick" kann auf Targetflanken (bekannt durch Zwischen-Pol-Target/ZPT-Kathoden) verzichtet werden. Dadurch wird die gesamte Targetoberfläche als aktiv sputternde Fläche wirksam und es besteht mit Vorteil nicht mehr die Gefahr der partiellen Belegung der Targetoberfläche.

Durch geschickte Ausbildung der das Target überspannenden Magnetfeldlinien kann zu dem ersten Plasma ein Sekundärplasma erzeugt werden. Dieses bildet sich als Plasmaring konzentrisch zu dem ersten Plasmaring aus und bewirkt eine Verbreiterung des Targeterosionsprofils.

Um die Targetlebensdauer zu erhöhen und die Sputterleistung bei weitgehend erodierten Targets gering zu halten, sollte das sich ausbildende Erosionsprofil möglichst breit in Relation zur Tiefe sein. Aus diesem Grund werden ringförmige Bleche aus nichtmagnetischem Material zwischen Target und Joch unter Einhaltung des Dunkelraumabstandes angebracht. Dadurch werden die senkrecht aus den Polschuhen austretenden Magnetfelder in ihrer Stärke auf die Targetoberfläche vergleichmäßigt, was zur Ausbildung breiter Erosionsgräben führt.

Durch die Abschrägung der Polschuhe überqueren die Magnetfeldlinien mit einem bestimmten Winkel die Targetoberfläche, der meist nicht parallel ist wie z. B. beim ZPT. Durch diese Neigung werden die Elektronen im wesentlichen nur bei neuen (nicht erodierten) Targets durch magnetischen Einfluß nahe der Targetoberfläche gehalten (Fokussierung der Elektronen Richtung Targetmitte).

Mit steigender Targeterosion wird der Sputtervorgang hauptsächlich durch parallele Magnetfeldlinien beeinflußt und es entsteht ein breites Erosionsprofil. Am Außendurchmesser des Targets bildet sich mit fortschreitender Erosion eine "Targetwand" aus, die den elektrostatischen Einschluß der Elektronen bewirkt. Ebenfalls vorteilhaft ist bei dieser erfindungsgemäßen Kathode, daß nur ein Magnetsatz gleich ausgerichteter Pole zur Erzeugung des Gesamtmagnetfeldes verwendet wird. Ein virtueller Gegenpol bildet sich in Kathodenmitte automatisch aus, ohne daß es zusätzlicher Magnete bedarf. Die Stärke des Magnetfeldes sowie dessen Struktur läßt sich durch Optimierung bzw. Anpassen des axialen Abstandes zwischen Polschuh und Magnet variieren. Vorteilhaft ist eine solche Anordnung der Magnete an die Atmosphäre; dadurch werden Überschläge zwischen Kathodenpotential (Target) und Jochpotential reduziert, da die Magnete im Vakuum nahe des Kathodenpotentials durch viele Streumagnetfelder und Hohlräume eine häufige Überschlagsquelle sind.

In dem Ausführungsbeispiel besteht die Anode beziehungsweise die auf Anodenpotential geschalteten Bauteile im wesentlichen aus dem eigentlichen Anodenring und einem Abschirmring. Die Anode ist als Teil der Prozeßkammer elektrisch isoliert und wird auch nur durch einen an der Atmosphärenseite angeordneten Kühlkanal gekühlt, so daß für die Anodenkühlung mit Vorteil kein Kühlmittelkreislauf innerhalb der Vakuumkammer erforderlich ist.

Weiterhin sind der Anoden- und der Abschirmring mit Vorteil so ausgestaltet, daß während des Zerstäubungsvorgangs nur der Abschirmring beschichtet werden kann und der Anodenring unbeeinflußt bleibt. Der Abschirmring ist austauschbar.

Die notwendige elektrische Anschlußleistung der Sputterstromversorgung konnte entscheidend reduziert werden. In einer Versuchsanlage, die bislang ca. 30 kW benötigte, kommt man mit der erfindungsgemäßen Kathodenanordnung nun mit der halben Leistung von ca. 15 kW aus.

Die meistverwendeten Targetwerkstoffe, insbesondere bei der Beschichtung kleiner Substrate, wie beispielsweise CD's, sind Al und AlCu-Legierungen. Mit der hier beschriebenen Erfindung ist auch eine Anwendung zum reaktiven Sputtern unterschiedlichster Targetwerkstoffe denkbar.

Weitere Ausführungsmöglichkeiten und Merkmale sind in den Unteransprüchen näher beschrieben und gekennzeichnet.

Die Erfindung läßt die verschiedensten Ausführungsmöglichkeiten zu; ein Beispiel ist in den anhängenden Zeichnungen näher dargestellt, und zwar zeigen:
- Fig. 1: einen Teilschnitt durch eine rotationssymmetrische, erfindungsgemäße Kathodenanordnung zur Beschichtung insbesondere kleiner, kreisscheibenförmiger Substrate und
- Fig. 2: eine stark vereinfachte Darstellung einer Kathodenanordnung gemäß Fig. 1 mit Magnetfeldlinienverlauf.

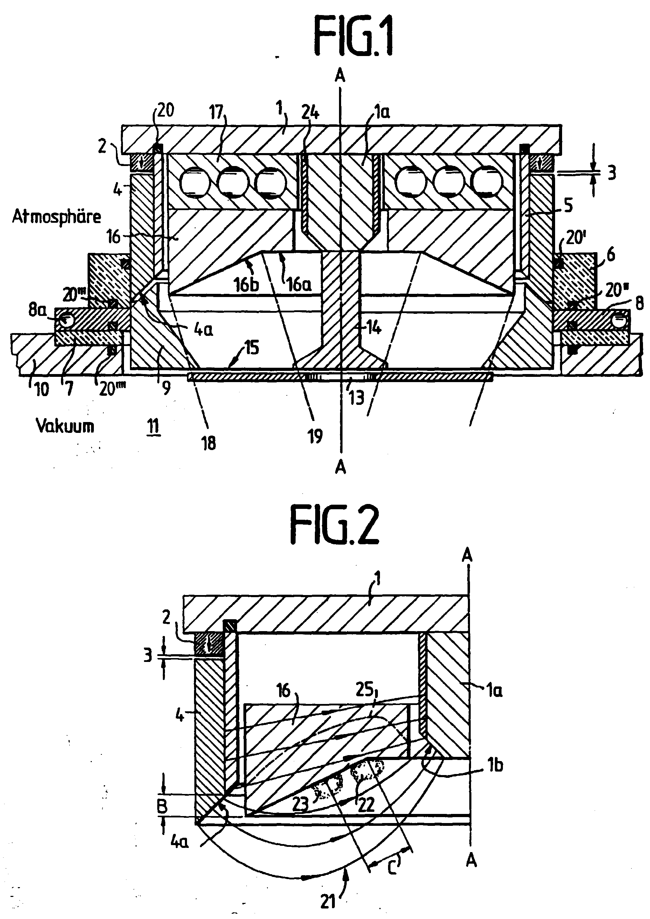

Ein im wesentlichen kreisscheibenförmiges Joch 1 (Fig.1) mit einem in Richtung der Rotationsachse A-A angeordnetem zentralen Polschuh 1a ist auf seiner Innenseite mit einem Ringmagnet 2 versehen. Über einen definierten axialen Abstand 3 schließt sich der Magnet 2, ein im wesentlichen hohlzylindrischer Polschuh 4, mit einer angeschrägten Stirnseite 4a an, wobei die Schräge zur Achse A-A hin zeigt. Der Polschuh 4 stützt sich gegen einen radial innen liegenden Blechring 5 aus nichtmagnetischem Werkstoff.

Zwischen zwei Isolationsringen 6,7 befindet sich eine ringförmige, mit einem Kühlkanal 8a versehene, Anode 8, an die sich in radialer Richtung ein Abschirmring 9 anschließt. In axialer Richtung ist die Anode 8 mit der Kaminerwand 10, einer Vakuumprozeßkammer 11, verbunden. Für die Abdeckung des Innenrandes des Substrats 13 ist eine Mittelmaske 14 vorgesehen, die mit dem zentralen Polschuh 1a verbunden ist.

Durch den als Blende ausgebildeten Abschirmring 9 und die Mittelmaske 14 wird eine ringförmige Öffnung 15 gebildet, von der das zu beschichtende, kreisscheibenförmige Substrat 13 positioniert ist.

Das zu zerstäubende Target 16 ist konzentrisch zur Achse A-A vorgesehen und über eine kühlbare Grundplatte 17 mit dem Joch 1 verbunden. Das Target 16 weist auf seiner zum Substrat 13 hin zugehenden Oberfläche einen Knick auf; dieser wird gebildet durch einen radial innenliegenden, ringförmigen Bereich 16a, der parallel zur Substratoberfläche verläuft und einen sich diesem Bereich direkt anschließenden radial außen liegenden Bereich 16b mit einer nach innen geneigten Oberfläche.

Dadurch wird der von diesem Bereich 16b abgestäubte Targetwerkstoff zum Substrat 13 hin fokussiert. Die Hauptzerstäubungsrichtung wird durch die beiden Linien 18, 19 markiert, die im wesentlichen lotrecht auf der Oberfläche des äußeren Bereichs 16b stehen und zur Achse A-A hin zeigen.

Die Bauteile 4,5,6,7 und 8, die das Target 16 in radialer Richtung umgeben, sind jeweils mit einem Dichtring 20,20',... vakuumdicht miteinander verbunden und bilden zusammen mit der Kammerwand 10 und dem Joch 1 einen das Target 16 umschließenden Vakuumraum. Dadurch wird ermöglicht, daß der Ringmagnet 2 an Atmosphäre angeordnet und die Kühlung der Anode 8 von der Atmosphärenseite her erfolgt.

In der Fig. 2 sind nochmals einige der in Fig. 1 bereits gezeigten Komponenten auszugsweise dargestellt, die zur Erläuterung des Wirkprinzips der erfindungsgemäßen Kathodenanordnung hilfreich sind. Das Joch 1 und der Polschuh 1a sind aus ferromagnetischem Werkstoff hergestellt. Ein einziger Ringmagnet 2 dient zur Erzeugung des Gesamtmagnetfeldes 21, wobei sich der Polschuh 1a automatisch als virtueller Gegenpol ausbildet, ohne daß es zusätzlicher Magnete bedarf. Die Magnetfeldlinien 21 treten zum einen aus der Stirnseite 4a des Polschuhs 4 aus und verlaufen bogenförmig vor dem Target 16 bis zur Stirnseite 1b des Polschuhs 1a. Zum anderen tritt ein Teil der Magnetfeldlinien 21 seitlich aus dem Polschuh 4 aus, durchdringt das Target 16 annähernd geradlinig und tritt wieder seitlich in den Polschuh 1a ein.

Durch die Abschrägung der Stirnseiten 1b und 4a der Polschuhe 1a und 4 verlaufen die Feldlinien 21 unter einem definierten Winkel zur Targetoberfläche. Dieser Verlauf bedingt den elektrostatischen Einschluß von Elektronen nahe der Targetoberfläche der notwendig ist, um Zündbedingungen für den Kathodenzerstäubungsvorgang zu erreichen. Diese Bedingung ist zuerst in dem Knick zwischen dem inneren 16a und dem schrägen äußeren Bereich 16b des Targets 16 gegeben, so daß sich hier zunächst ein erster Plasmaschlauch 22 ausbildet.

Bei der skizzierten Ausbildung des Magnetfeldes 21 liegt der Nulldurchgang der Magnetfeldlinien 21 in etwa in der radial innenliegenden ersten Hälfte des angeschrägten Bereichs 16b der Targetoberfläche, so daß sich hier ein zweiter Plasmaschlauch 23 ausbildet.

Die Stärke, sowie die Struktur des Magnetfeldes 21 ist durch Variation des Abstandes 3 zwischen Magnet 2 und Polschuh 4 anpassungsfähig.

### Bezugszeichenliste

- 1: Joch
- 1a: Polschuh
- 1b: Stirnseite
- 2: Ringmagnet, Magnetsatz
- 3: Abstand
- 4: Polschuh
- 4a: Stirnseite
- 5: Ring
- 6: Isolationsring
- 7: Isolationsring
- 8: Anode
- 8a: Kühlkanal
- 9: Abschirmring
- 10: Kammerwand
- 11: Vakuum-Prozeßkammer
- 13: Substrat
- 14: Mittelmaske
- 15: Öffnung
- 16: Target
- 16a: Bereich, Fläche innen
- 16b: Bereich, Fläche außen
- 17: Grundplatte
- 18: Linie
- 19: Linie
- 20,20',...: Dichtring
- 21: Magnetfeld, -linien
- 22: Plasmaschlauch
- 23: Plasmaschlauch
- 24: Ring
- 25: Sputtergraben
- A-A: Rotationsachse
- B: Abstand
- C: Abstand

## Patentansprüche

1. Vorrichtung zur Kathodenzerstäubung für die Herstellung dünner Schichten auf einem Substrat (13) mittels eines Plasmas (22) in einer Vakuumprozeßkammer (11), im wesentlichen bestehend aus Magneten (2), Polschuhen (1a, 4), einer Anode (8), einem als Kathode ausgebildeten Target (16) aus dem zu zerstäubenden Werkstoff und einer Abschirmung (9), wobei die dem Substrat (13) zugewandte, zu zerstäubende Vorderseite des Targets (16) im wesentlichen dachförmig verläuft und die Dachflächen (16a, 16b) symmetrisch zur Rotationsachse A-A des Targets ausgeführt sind, die Dachform durch mindestens zwei oder mehr Ebenen gebildet wird und die Senkrechten (18, 19), die auf den Vorderseiten der beiden längsten Ebenen erzeugbar sind, ihren gemeinsamen Schnittpunkt vor dem Target (16) haben, **dadurch gekennzeichnet**, daß
a) nur ein Magnetsatz (2) mit einem das Target (16) umgebenden ersten Polschuh (4) und einem zentral angeordneten zweiten Polschuh (1a), wobei das Target (16) den zweiten Polschuh (1a) umgibt, verwendet wird, und daß,
b) die dem Substrat (13) zugewandten Stirnseiten (1b,4a) der Polschuhe (1a,4) mit einer Schräge versehen sind, wobei die Schräge des ersten Polschuhs (4) zur Rotationsachse A-A hin zeigt und die Schräge des zweiten Polschuhs (1a) von der Rotationsachse A-A weg zeigt.

2. Vorrichtung nach Anspruch 1, **dadurch gekennzeichnet**, daß die einen Ringmagneten (2), einen hohlzylindrischen und einen zentralen Polschuh (1a bzw. 4), einen Abschirmring (9), eine ringförmige Anode (8) und ein Target (16) mit Dachflächen (16a, 16b) aufweisende Kathodenanordnung rotationssymmetrisch zur Achse (A-A) ausgebildet ist.

3. Vorrichtung nach Anspruch 1, **dadurch gekennzeichnet**, daß der Magnetsatz (2) aus gleichgerichteten Einzelmagneten besteht.

4. Vorrichtung nach Anspruch 1, **dadurch gekennzeichnet**, daß der Magnetsatz (2) das Target (16) radial umschließt und an der Atmosphärenseite der Prozeßkammer (11) angeordnet ist.

5. Vorrichtung nach den Ansprüchen 1 und 2, **dadurch gekennzeichnet**, daß zwischen dem Ringmagneten (2) und dem hohlzylindrischen Polschuh (4) ein Abstand (3) in Richtung der Achse A-A vorgesehen ist.

6. Vorrichtung nach Anspruch 5, **dadurch gekennzeichnet**, daß der Abstand (3) einstellbar ist.

7. Vorrichtung nach Anspruch 1, **dadurch gekennzeichnet**, daß die radial äußere Vorderkante eines neuen, unverbrauchten Targets (16) die radial innere Vorderkante des ersten Polschuhes (4) in Richtung auf das Substrat (13) um den Abstand B überragt.

8. Vorrichtung nach Anspruch 1, **dadurch gekennzeichnet**, daß zwischen dem zentral angeordneten Target (16) und dem das Target umgebenden ersten Polschuh (4) ein erster Ring (5) aus nicht magnetischem Werkstoff vorgesehen ist.

9. Vorrichtung nach Anspruch 1, **dadurch gekennzeichnet**, daß zwischen dem zentral angeordneten zweiten Polschuh (1a) und dem, den zweiten Polschuh (1a) umgebenden Target (16) ein zweiter Ring (24) aus nicht magnetischem Werkstoff vorgesehen ist.

10. Vorrichtung nach Anspruch 8 und 9, **dadurch gekennzeichnet**, daß die ersten und zweiten Ringe (5, 24) jeweils im Dunkelraumabstand zum Target (16) angeordnet sind.

11. Vorrichtung nach Anspruch 1**, dadurch gekenn****zeichnet**, daß die das Target (16) umgebenden Bauteile Joch (1), erster Ring (5), Polschuh (4), Anode (8), Isolationsringe (6, 7) und die Kammerwand (10) vakuumdicht mit dem jeweils benachbarten Bauteil verbunden sind.

12. Vorrichtung nach Anspruch 11, **dadurch gekennzeichnet**, daß zwischen den Bauteilen nach Anspruch 8 (1,4,5,6,7,8,10) jeweils ein Dichtring (20,20',...) montiert ist.

13. Vorrichtung nach Anspruch 1, **dadurch gekennzeichnet**, daß die das Target (16) umgebenden Bauteile Joch (1), Ring (5), Polschuh (4), Isolationsringe (6,7), Anode (8) und die Kammerwand (10) kraftschlüssig miteinander verbunden sind.

14. Vorrichtung nach Anspruch 1, **dadurch gekennzeichnet**, daß ein Kühlkanal (8a) in dem radial außen liegenden Bereich der Anode (8) vorgesehen ist.

15. Vorrichtung nach Anspruch 14, **dadurch gekennzeichnet**, daß der radial äußere Bereich der Anode (8) unter Atmosphärendruck liegt und nur dort gekühlt wird.

16. Vorrichtung nach Anspruch 1, **dadurch gekennzeichnet**, daß die Anode (8) mit einem Abschirmring (9) direkt verbunden ist.

17. Vorrichtung nach Anspruch 16, **dadurch gekennzeichnet**, daß die Anode (8) mit dem Abschirmring (9) im Dunkelraumabstand zum Target (16) angeordnet ist.

18. Vorrichtung nach Anspruch 1, **dadurch gekennzeichnet**, daß der erste Polschuh (4), der Ring (5), der Magnetsatz (2), das Joch (1), der Polschuh (1a) sowie der zweite Ring (24), in Betrieb, auf Anodenpotential geschaltet sind.

19. Vorrichtung nach den Ansprüchen 1 und 2, **dadurch gekennzeichnet**, daß der von der ringförmigen Anode (8) umgriffene Abschirmring (9), sowie eine mit dem zentralen Polschuh (1a) verbundene Mittelmaske (14) auf elektrisch floatendem Potential liegen.

20. Vorrichtung nach Anspruch 1, **dadurch gekennzeichnet**, daß das zu beschichtende Substrat (13) flach und kreisscheibenförmig ist.

21. Vorrichtung nach Anspruch 1, **dadurch gekennzeichnet**, daß ein erstes Plasma (22) durch elektrostatischen Einschluß in dem dachförmigen Knick auf der Targetvorderseite erzeugt wird.

22. Vorrichtung nach Anspruch 1, **dadurch gekennzeichnet,** aß die Schräge der Stirnseite (4a) des Polschuhes (4) so ausgebildet ist, daß die von ihr austretenden Magnetfeldlinien (21) die Vorderseite des Targets (16) bogenförmig überspannen und in die Stirnseite (1b) des zentrisch angeordneten zweiten Polschuhs (1a) wieder eintreten.

23. Vorrichtung nach Anspruch 1, **dadurch gekennzeichnet**, daß das Magnetfeld (21) so ausgebildet ist, daß die senkrechte Projektion des Magnetfeldes (21) auf die dachförmige Ebene des äußeren Bereichs (16b) des Targets (16) auftrifft.

24. Vorrichtung nach Anspruch 1, **dadurch gekennzeichnet**, daß an der Auftreffstelle nach Anspruch 23 ein zweites Plasma (23) erzeugbar ist.

25. Vorrichtung nach Anspruch 24, **dadurch gekennzeichnet**, daß beide Plasmen ( 22,23) ringförmig sind.

26. Vorrichtung nach Anspruch 24, **dadurch gekennzeichnet**, daß das zweite Plasma (23) in einem Abstand C zu dem ersten Plasma (22) erzeugt wird.

27. Vorrichtung nach Anspruch 26, **dadurch gekennzeichnet**, daß der Abstand C so bemessen ist, so daß eine Verteilung der Plasmaintensität auf der Targetvorderseite mit zwei Maxima erreicht wird.

28. Vorrichtung nach Anspruch 27, **dadurch gekennzeichnet**, daß durch die zwei beabstandeten Plasmen (22,23) ein Sputtergraben (25) mit einem im Querschnitt breiten Grabenprofil erzeugt wird.

## Claims

1. Apparatus for cathode sputtering for the production of thin coatings on a substrate (13) by means of a plasma (22) in a vacuum processing chamber (11), substantially consisting of magnets (2), pole shoes (1a, 4), an anode (8), a target (16) in the form of a cathode composed of the material to be sputtered and a screen (9), wherein the front face, facing the substrate (13), of the target (16) to be sputtered is substantially roof-shaped and the roof faces (16a, 16b) are symmetrical to the axis of rotation A-A of the target and the roof form is formed by at least two or more planes and the perpendicular lines (18, 19) which can be generated on the front faces of the two longest planes have their common point of intersection in front of the target (16), characterised in that
a) only one magnet set (2) having a first pole shoe (4) surrounding the target (16) and a centrally disposed second pole shoe (1a) is used, the target (16) surrounding the second pole shoe (1a), and in that
b) the end faces (1b, 4a) of the pole shoes (1a, 4) facing the substrate (13) are provided with a slope, the slope of the first pole shoe (4) pointing to the axis of rotation A-A and the slope of the second pole shoe (1a) pointing away from the axis of rotation A-A.

2. Apparatus according to claim 1, characterised in that the cathode arrangement having an annular magnet (2), a hollow-cylindrical and a central pole shoe (1a and 4 respectively), a screening ring (9), an annular anode (8) and a target (16) with roof faces (16a, 16b) is formed with rotational symmetry about the axis (A-A).

3. Apparatus according to claim 1, characterised in that the magnet set (2) consists of individual magnets with the same orientation.

4. Apparatus according to claim 1, characterised in that the magnet set (2) radially encloses the target (16) and is disposed on the atmosphere side of the processing chamber (11).

5. Apparatus according to claims 1 and 2, characterised in that between the annular magnet (2) and the hollow-cylindrical pole shoe (4) a gap (3) is provided in the direction of the axis A-A.

6. Apparatus according to claim 5, characterised in that the gap (3) is adjustable.

7. Apparatus according to claim 1, characterised in that the radially outer front edge of a new, unused target (16) projects beyond the radially inner front edge of the first pole shoe (4) in the direction of the substrate (13) by the distance B.

8. Apparatus according to claim 1, characterised in that between the centrally disposed target (16) and the first pole shoe (4) surrounding the target, a first ring (5) of non-magnetic material is provided.

9. Apparatus according to claim 1, characterised in that between the centrally disposed second pole shoe (1a) and the target (16) surrounding the second pole shoe (1a), a second ring (24) of non-magnetic material is provided.

10. Apparatus according to claim 8 and 9, characterised in that the first and second rings (5, 24) are each disposed at darkroom distance from the target (16).

11. Apparatus according to claim 1, characterised in that the components yoke (1), first ring (5), pole shoe (4), anode (8), insulation rings (6, 7) and the chamber wall (10) surrounding the target (16) are connected in a vacuum-tight manner to the respectively adjacent component.

12. Apparatus according to claim 11, characterised in that between the components according to claim 8 (1, 4, 5, 6, 7, 8, 10) a sealing ring (20, 20', ...) is respectively mounted.

13. Apparatus according to claim 1, characterised in that the components yoke (1), ring (5), pole shoe (4), insulation rings (6, 7), anode (8) and chamber wall (10) surrounding the target (16), are joined together non-positively.

14. Apparatus according to claim 1, characterised in that a cooling channel (8a) is provided in the radially outer region of the anode (8).

15. Apparatus according to claim 14, characterised in that the radially outer region of the anode (8) is at atmospheric pressure and only there does cooling occur.

16. Apparatus according to claim 1, characterised in that the anode (8) is directly connected to a screening ring (9).

17. Apparatus according to claim 16, characterised in that the anode (8) with the screening ring (9) is disposed at darkroom distance from the target (16).

18. Apparatus according to claim 1, characterised in that the first pole shoe (4), the ring (5), the magnet set (2), the yoke (1), the pole shoe (1a) and the second ring (24) are switched to anode potential in operation.

19. Apparatus according to claims 1 and 2, characterised in that the screening ring (9) surrounded by the annular anode (8), as well as a central mask (14) connected to the central pole shoe (1a) are at electrically floating potential.

20. Apparatus according to claim 1, characterised in that the substrate (13) to be coated is flat and circular disc-shaped.

21. Apparatus according to claim 1, characterised in that a first plasma (22) is generated by electrostatic inclusion in the roof-shaped bend on the target front face.

22. Apparatus according to claim 1, characterised in that the slope of the end face (4a) of the pole shoe (4) is so formed that the magnetic field lines (21) emerging therefrom span the front face of the target (16) in a curved manner and re-enter the end face (1b) of the centrally disposed second pole shoe (1a).

23. Apparatus according to claim 1, characterised in that the magnetic field (21) is so formed that the perpendicular projection of the magnetic field (21) meets the roof-shaped plane of the outer region (16b) of the target (16).

24. Apparatus according to claim 1, characterised in that at the point of impact according to claim 23, a second plasma (23) can be generated.

25. Apparatus according to claim 24, characterised in that both plasmas (22, 23) are annular.

26. Apparatus according to claim 24, characterised in that the second plasma (23) is generated at a distance C from the first plasma (22).

27. Apparatus according to claim 26, characterised in that the distance C is so dimensioned that a distribution of the plasma intensity on the target front face with two maxima is achieved.

28. Apparatus according to claim 27, characterised in that by the two spaced plasmas (22, 23) a sputter groove (25) with a groove profile of wide cross-section is achieved.

## Revendications

1. Dispositif de pulvérisation cathodique pour la réalisation de minces couches sur un substrat (13) au moyen d'un plasma (22) dans une chambre de traitement sous vide (11), constitué essentiellement par des aimants (2), des pièces polaires (1a, 4), une anode (8), une cible (16) en la matière à pulvériser et réalisée sous forme de cathode, et par un blindage (9), la face antérieure à pulvériser de la cible (16), tournée vers le substrat (13), s'étendant sensiblement en forme de toiture et les surfaces en forme de toiture (16a, 16b) étant réalisées symétriques à l'axe de rotation A-A de la cible, la forme de toiture étant réalisée par au moins deux ou plusieurs plans, et les perpendiculaires (18, 19) susceptibles d'être engendrées sur les faces antérieures des deux plans les plus longs ayant leur point d'intersection commun devant la cible (16), caractérisé en ce que
a) on utilise seulement un jeu d'aimants (2) avec une première pièce polaire (4) entourant la cible (16) et une seconde pièce polaire (1a) agencée au centre, la cible (16) entourant la seconde pièce polaire (1a), et en ce que
b) les faces frontales (1b, 4a), tournées vers le substrat (13), des pièces polaires (1a, 4) sont pourvues d'une pente, ladite pente de la première pièce polaire (4) étant orientée vers l'axe de rotation A-A, et la pente de la seconde pièce polaire (1a) étant orientée en éloignement de l'axe de rotation A-A.

2. Dispositif selon la revendication 1, caractérisé en ce que l'agencement cathodique présentant un aimant annulaire (2), une pièce polaire cylindrique creuse (1a) et une pièce polaire centrale (4), un anneau de blindage (9), une anode annulaire (8) et une cible (16) à surfaces en toiture (16a, 16b) est réalisé à symétrie de révolution par rapport à l'axe (A-A).

3. Dispositif selon la revendication 1, caractérisé en ce que le jeu d'aimants (2) est constitué par des aimants individuels de même orientation.

4. Dispositif selon la revendication 1, caractérisé en ce que le jeu d'aimants (2) entoure radialement la cible (16), et est agencé sur le côté atmosphère de la chambre de traitement (11).

5. Dispositif selon l'une ou l'autre des revendications 1 et 2, caractérisé en ce qu'il est prévu, entre l'aimant annulaire (2) et la pièce polaire (4) cylindrique creuse, un espacement (3) en direction de l'axe A-A.

6. Dispositif selon la revendication 5, caractérisé en ce que l'espacement (3) est réglable.

7. Dispositif selon la revendication 1, caractérisé en ce que le bord antérieur radialement extérieur d'une nouvelle cible (16) inutilisée dépasse, du montant de l'espacement B, le bord antérieur radialement intérieur de la première pièce polaire (4) en direction du substrat (13).

8. Dispositif selon la revendication 1, caractérisé en ce qu'il est prévu, entre la cible (16) à agencement central et la première pièce polaire (4) entourant la cible, un premier anneau (5) en matériau amagnétique.

9. Dispositif selon la revendication 1, caractérisé en ce qu'il est prévu, entre la seconde pièce polaire (1a) à agencement central et la cible (16) entourant la seconde pièce polaire (1a), un second anneau (24) en matériau amagnétique.

10. Dispositif selon les revendications 8 et 9, caractérisé en ce que le premier et le second anneau (5, 24) sont chacun agencés à distance d'espace obscur par rapport à la cible (16).

11. Dispositif selon la revendication 1, caractérisé en ce que les éléments entourant la cible (16), tels que la culasse (1), le premier anneau (5), la pièce polaire (4), l'anode (8), les anneaux d'isolement (6, 7) et la paroi de chambre (19) sont reliés de manière étanche au vide avec l'élément voisin respectif.

12. Dispositif selon la revendication 11, caractérisé en ce qu'une bague d'étanchéité (20, 20',...) respective est montée entre les éléments (1, 4, 5, 6, 7, 8, 10) de la revendication 8.

13. Dispositif selon la revendication 1, caractérisé en ce que les éléments entourant la cible (16), tels que la culasse (1), le premier anneau (5), la pièce polaire (4), l'anode (8), les anneaux d'isolement (6, 7) et la paroi de chambre (19) sont reliés les uns aux autres par coopération de forces.

14. Dispositif selon la revendication 1, caractérisé en ce qu'un canal de refroidissement (8a) est prévu dans la zone située radialement à l'extérieur de l'anode (8).

15. Dispositif selon la revendication 14, caractérisé en ce que la zone radialement extérieure de l'anode (8) se trouve sous pression atmosphérique et n'est refroidie qu'à cet endroit.

16. Dispositif selon la revendication 1, caractérisé en ce que l'anode (8) est directement reliée à un anneau de blindage (9).

17. Dispositif selon la revendication 16, caractérisé en ce que l'anode (8) est agencée avec l'anneau de blindage (9) à distance de l'espace obscur par rapport à la cible (16).

18. Dispositif selon la revendication 1, caractérisé en ce que la première pièce polaire (4), l'anneau (5), le jeu d'aimants, la culasse (1), la pièce polaire (1a) ainsi que le second anneau (24) sont branchés en fonctionnement au potentiel anodique.

19. Dispositif selon les revendications 1 et 2, caractérisé en ce que l'anneau de blindage (9) entouré par l'anode (8) annulaire ainsi qu'un masque médian (14) relié à la pièce polaire (1a) centrale sont branchés à un potentiel électrique flottant.

20. Dispositif selon la revendication 1, caractérisé en ce que le substrat (13) à revêtir est plat et en forme de disque circulaire.

21. Dispositif selon la revendication 1, caractérisé en ce qu'un premier plasma (22) est engendré sur la face antérieure de la cible par inclusion électrostatique dans la pliure en forme de toiture.

22. Dispositif selon la revendication 1, caractérisé en ce que la pente de la face frontale (4a) de la pièce polaire (4) est réalisée de telle sorte que les lignes de champ (21) qui en émanent recouvrent en forme d'arc la face antérieure de la cible (16) et entrent de nouveau dans la face frontale (1b) de la seconde pièce polaire (1a) agencée au centre.

23. Dispositif selon la revendication 1, caractérisé en ce que le champ magnétique (21) est réalisé de telle sorte que la projection perpendiculaire du champ magnétique (21) est incidente sur le plan en forme de toiture de la zone extérieure (16b) de la cible (16).

24. Dispositif selon la revendication 1, caractérisé en ce qu'un second plasma (23) est susceptible d'être produit au niveau du point d'incidence selon la revendication 23.

25. Dispositif selon la revendication 24, caractérisé en ce que les deux plasmas (22, 23) sont de forme annulaire.

26. Dispositif selon la revendication 24, caractérisé en ce que le second plasma (23) est produit à un espacement C par rapport au premier plasma (22).

27. Dispositif selon la revendication 26, caractérisé en ce que l'espacement C est choisi de manière à obtenir une répartition avec deux maxima de l'intensité du plasma sur la face antérieure de la cible.

28. Dispositif selon la revendication 27, caractérisé en ce que les deux plasmas (22, 23) espacés produisent une fosse de pulvérisation cathodique (25) avec un profil de fosse de section large.
